## Europäisches Patentamt

## European Patent Office

## Office européen des brevets

(19)

(11) Veröffentlichungsnummer: **0 150 361**
A2

# EUROPÄISCHE PATENTANMELDUNG

(12)

(21) Anmeldenummer: 84115055.0

(22) Anmeldetag: 10.12.84

(51) Int. Cl.⁴: **H 01 H 33/00**

(30) Priorität: 27.01.84 DE 3402828

(43) Veröffentlichungstag der Anmeldung: 07.08.85
Patentblatt 85/32

(84) Benannte Vertragsstaaten: DE FR GB NL

(71) Anmelder: **Siemens Aktiengesellschaft, Berlin und München Wittelsbacherplatz 2, D-8000 München 2 (DE)**

(72) Erfinder: **Franksen, Holger, Schenkstrasse 47, D-8520 Erlangen (DE)**

(54) **Schalteinrichtung zum Kurzschliessen mindestens einer supraleitenden Magnetwicklung.**

(57) Die Schalteinrichtung zum Kurzschließen mindestens einer supraleitenden Magnetwicklung enthält mindestens zwei von einem kryogenen Medium zu kühlende Kontaktstücke, die mittels einer Betätigungsvorrichtung so aneinanderzufügen sind, daß ein supraleitender Strompfad und ein den supraleitenden Strompfad vollstabilisierender normalleitender Strompfad ausgebildet sind. Diese Schalteinrichtung soll in ihrem geöffneten Schaltzustand einen verhältnismäßig großen ohmschen Widerstand aufweisen. Die Erfindung sieht hierzu vor, daß ein ständig geschlossener Strompfad mit mindestens einem teilstabilisierten Supraleiter (6) mit einem Widerstand von mindestens 200 Ohm im normalleitenden Zustand des Supraleiters (6) vorgesehen ist, daß ferner der teilstabilisierte Supraleiter (6) in einer vorbestimmten Anzahl von Windungen (w) mit einer schaltbaren Heizvorrichtung (3) in thermischem Kontakt, elektrisch isoliert verbunden ist, daß darüber hinaus mindestens zwei Kontaktstücke (10, 11) aus normalleitendem Material vorgesehen sind, die jeweils über einen elektrischen Leiter (12 bzw. 13) an die Magnetwicklung anzuschließen sind, und daß außerdem an den teilstabilisierten Supraleiter (6) die normalleitenden Kontaktstücke (10, 11) so anzufügen sind, daß die zwischen diesen Kontaktstücken (10, 11) verlaufenden Teilstücke (t) des Supraleiters (6) zumindest teilweise durch die Kontaktstücke (10, 11) parallelgeschaltet sind.

SIEMENS AKTIENGESELLSCHAFT     Unser Zeichen

Berlin und München     VPA **84 P 3016 E**

Schalteinrichtung zum Kurzschließen mindestens
einer supraleitenden Magnetwicklung

Die Erfindung bezieht sich auf eine Schalteinrichtung zum Kurzschließen mindestens einer supraleitenden Magnetwicklung mit mindestens zwei von einem kryogenen Medium zu kühlenden Kontaktstücken, die mittels einer Betätigungsvorrichtung so aneinanderzufügen sind, daß ein supraleitender Strompfad und ein den supraleitenden Strompfad vollstabilisierender normalleitender Strompfad ausgebildet sind. Eine entsprechende Schalteinrichtung ist aus der DE-OS 25 21 328 bekannt.

Sobald das magnetische Feld einer supraleitenden Magnetwicklung, insbesondere einer Hochfeldmagnetspule, einmal aufgebaut ist, braucht zur Aufrechterhaltung des Feldes der Spule von außen praktisch keine weitere elektrische Energie mehr zugeführt zu werden. Dann ist lediglich der Energiebedarf der zur Aufrechterhaltung des supraleitenden Zustandes der Wicklung benötigten Kälteeinrichtungen noch zu decken. Zur Speicherung der in die Magnetwicklung eingespeisten elektrischen Energie kann man deshalb die Magnetwicklung an ihren Enden mittels einer möglichst widerstandsarmen Schalteinrichtung kurzschließen. Der Strom fließt dann fast ungedämpft in dem so ausgebildeten, kurzgeschlossenen Stromkreis, und die zur Erregung der Magnetwicklung erforderliche Stromversorgung kann somit unterbrochen werden.

Die aus der eingangs genannten DE-OS bekannte Schalteinrichtung enthält zwei Kontaktstücke, die jeweils ein Trägerelement aus normalleitendem Material als Matrix aufweisen, in der untereinander parallel angeordnete

Slm 2 Sir / 23.01.1984

supraleitende Leiterstücke eingebettet sind. Die Kontaktstücke werden dabei indirekt von einem kryogenen Kühlmittel auf der Betriebstemperatur der supraleitenden
Leiterstücke gehalten. Eine zum Öffnen und Schließen der
Schalteinrichtung erforderliche mechanische Betätigungsvorrichtung ist so gestaltet, daß jeweils die supraleitenden Leiterstücke der beiden Kontaktstücke sowie ihre
normalleitenden Teile aneinandergefügt werden können, um
so einen supraleitenden Strompfad und einen den supraleitenden Strompfad vollstabilisierenden normalleitenden
Strompfad zu bilden. Unter einer Vollstabilisierung wird
dabei ein ausreichender Leiterquerschnitt des parallel
zum supraleitenden Strompfad liegenden normalleitenden
Strompfades verstanden, um im Normalleitungsfalle des
supraleitenden Strompfades den gesamten Betriebsstrom
ohne Beschädigung der Schalteinrichtung zumindest für
kürzere Zeit führen zu können.

Bei dieser Schalteinrichtung ist die Oberfläche des einen Kontaktstückes gekrümmt gestaltet, während das andere Kontaktstück z. B. eine ebene oder eine konkav geformte Oberfläche aufweisen kann. Um einen geringen
Übergangswiderstand zwischen den supraleitenden Leiterstücken der beiden Kontaktstücke zu gewährleisten, ist
neben einer exakten Führung der Kontaktstücke auch eine
verhältnismäßig hohe Kontaktkraft erforderlich. Dennoch
kann dabei nicht immer gewährleistet werden, daß alle
entsprechenden supraleitenden Leiterstücke der beiden
Kontaktstücke mit etwa gleicher Kontaktkraft aneinandergefügt werden und somit annähernd gleiche Übergangswiderstände in dem entsprechenden supraleitenden Strompfad hervorrufen. Vielmehr ist davon auszugehen, daß
einzelne supraleitende Leiterstücke nur mit verhältnismäßig geringer Kontaktkraft aneinanderliegen und somit
zu entsprechend hohen Übergangswiderständen führen. Bei der bekannten Schalteinrichtung lassen sich somit reproduzierbare Widerstände in der Größenordnung von $10^{-9}$ Ohm oder weniger während längerer Zeit nicht ohne weiteres gewährleisten. Derartig geringe Widerstände werden aber insbesondere für Schalteinrichtungen zum Kurzschließen von supraleitenden Großmagneten, wie sie z. B. für Einrichtungen der Kernfusion oder zur Kernspintomographie vorzusehen sind, gefordert.

Neben derartigen mechanischen Schalteinrichtungen mit dem Problem der Langzeitkonstanz und Reproduzierbarkeit des Widerstandes im geschlossenen Zustand sind auch supraleitende Schalteinrichtungen bekannt, deren supraleitender Strompfad zur Ausbildung eines quasi geöffneten Zustandes der Schalteinrichtung durch eine besondere Heizvorrichtung in Normalleitung versetzt wird (vgl. DE-OS 31 35 177). Bei der Verwendung hochstabilisierter Supraleiter für derartige Schalteinrichtungen ergibt sich jedoch das Problem eines zu geringen Widerstandes bei geöffnetem Schaltzustand, so daß nur eine entsprechend langsame Auferregung der supraleitenden Magnetwicklung möglich ist. Verwendet man deshalb nur teilstabilisierte Supraleiter, so ist damit eine dementsprechend geringe Stromtragfähigkeit im geschlossenen Zustand gegeben. Mit dem Einsatz schlecht leitender Stabilisierungsmaterialien, z. B. einer Kupfer-Nickel- Legierung anstatt von Kupfer, wird zwar ein höherer Widerstand der Schalteinrichtung bei geöffnetem Zustand und eine im allgemeinen hinreichende Stromtragfähigkeit im geschlossenen Zustand erreicht. Für eine schnelle Erregung insbesondere großer Magnete mit hoher Induktivität reicht aber auch hier der Widerstand der Schalteinrichtung im geöffneten Zustand nicht aus. Ferner treten als weitere Schwierigkeiten noch größere Kontaktwiderstände zwischen dem kupfer-nickel-stabilisierten Schaltermaterial und dem im allgemeinen kupferstabilisierten Leiter des Magneten auf.

Aufgabe der Erfindung ist es deshalb, die eingangs genannte Schalteinrichtung dahingehend zu verbessern, daß mit ihr ein Kurzschluß der supraleitenden Magnetwicklung mit sehr kleinem Widerstand von $10^{-9}$ Ohm oder weniger im geschlossenen Zustand und ein hinreichend grosser Widerstand von z. B. 200 Ohm oder mehr im offenen Zustand auf verhältnismäßig einfache Weise zu erreichen sind. Hierbei soll eine ausreichende Stabilisierung und hinreichend große Stromtragfähigkeit der Schalteinrichtung im geschlossenen Zustand gewährleistet sein.

Diese Aufgabe wird erfindungsgemäß dadurch gelöst, daß ein ständig geschlossener Strompfad mit mindestens einem teilstabilisierten Supraleiter mit einem Widerstand von mindestens 200 Ohm im normalleitenden Zustand des Supraleiters vorgesehen ist, daß der teilstabilisierte Supraleiter in einer vorbestimmten Anzahl von Windungen mit einer schaltbaren Heizvorrichtung in thermischem Kontakt, elektrisch isoliert verbunden ist, daß mindestens zwei Kontaktstücke aus normalleitendem, elektrisch gut leitendem Material vorgesehen sind, die jeweils über einen elektrischen Leiter an die Magnetwicklung anzuschließen sind, und daß an den teilstabilisierten Supraleiter die normalleitenden Kontaktstücke so anzufügen sind, daß die zwischen diesen Kontaktstücken verlaufenden Teilstücke des Supraleiters zumindest teilweise durch die Kontaktstücke parallelgeschaltet sind.

Der geforderte ohmsche Mindestwert des teilstabilisierten Supraleiters dieser Schalteinrichtung läßt sich ohne weiteres durch eine entsprechende Bemessung der Leiterlänge und durch eine Begrenzung des Querschnitts an Stabilisierungsmaterial reichen. Die Anzahl der Windungen des teilstabilisierten Supraleiters legt die Anzahl der mittels der normalleitenden Kontaktstücke parallelgeschalteten

0150361

Teilstücke des Supraleiters fest und ist durch die mit dieser Parallelschaltung erreichbare gemeinsame Stromtragfähigkeit dieser Teilstücke bestimmt. Die beiden normalleitenden Kontaktstücke weisen einen vorbestimmten Leiterquerschnitt auf und bestehen beispielsweise aus dem gleichen Stabilisierungsmaterial, wie es für den teilstabilisierten Supraleiter vorgesehen ist.

Die mit der erfindungsgemäßen Ausgestaltung der Schalteinrichtung verbundenen Vorteile sind insbesondere darin zu sehen, daß sich ein sehr geringer Widerstand im geschlossenen Schalterzustand und ein verhältnismäßig hoher Widerstand im geöffneten Schalterzustand erreichen läßt. Zugleich läßt sich eine gute Stromtragfähigkeit und Stabilisierung mittels der normalleitenden Kontaktstücke im geschlossenen Zustand gewährleisten. Außerdem ist eine gute Kontaktierbarkeit des Schaltermaterials mit dem Leiter der Magnetwicklung ermöglicht.

Vorteilhafte Ausgestaltungen der Schalteinrichtung nach der Erfindung gehen aus den Unteransprüchen hervor.

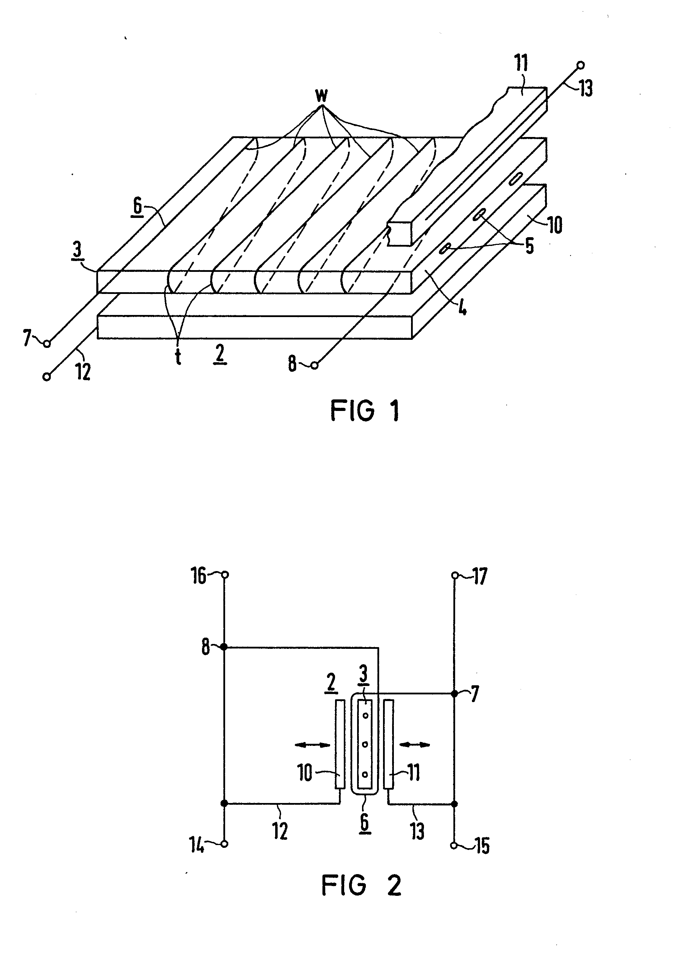

Zur weiteren Erläuterung der Erfindung wird auf die Zeichnung Bezug genommen, in deren Figuren 1 und 2 ein Ausführungsbeispiel einer erfindungsgemäßen Schalteinrichtung als Schrägansicht bzw. in einer Schaltskizze schematisch veranschaulicht ist.

Die in Fig. 1 angedeutete und mit 2 bezeichnete Schalteinrichtung ist im geöffneten Schalterzustand gezeigt. Sie weist eine plattenförmige Heizvorrichtung 3 auf, welche eine Trägerplatte 4 aus nicht-leitendem Material enthält, in der mehrere Heizleitungen 5 angeordnet sind. Um die so ausgebildete Heizvorrichtung 3 ist eine Vielzahl von Windungen w eines drahtförmiges Supraleiters 6 gewickelt. Dieser Supraleiter soll nur teilstabilisiert sein, d. h., sein supraleitendes Material ist dann nur mit einem verhältnismäßig geringen Querschnitt an elektrisch gut leitendem, normalleitendem Material verbunden, das nur einen Teil eines vorbestimmten Betriebsstromes ohne Beschädigung des gesamten Supraleiters zu führen in der Lage ist. Zweckmäßig wird ein Stabilisierungsgrad $\alpha$ , d. h. das Verhältnis von Anteil an normalleitendem Stabilisierungsmaterial zu Anteil an supraleitendem Material, von höchstens 1 gewählt. Der Supraleiter 6 ist an Anschlüssen 7 und 8 mit den entsprechenden Enden mindestens einer in der Figur nicht dargestellten supraleitenden Magnetwicklung elektrisch leitend zu verbinden. Bei der Magnetwicklung kann es sich beispielsweise um die Wicklung eines Magnetsystems zur Erzeugung des magnetischen Grundfeldes einer Anlage zur Kernspintomographie oder um die Wicklung eines Magneten einer Kernfusionsanlage handeln. Diese Wicklungen werden im allgemeinen aus vollstabilisierten Supraleitern aufgebaut, welche sich mit dem Supraleiter 6 leicht zu einem Kurzschlußkreis verbinden lassen.

Der um die elektrisch nicht-leitende, heizbare Trägerplatte 4 angeordnete Supraleiter 6 stellt somit einen supraleitenden Kurzschluß- oder Dauerstromschalter dar, welcher in bekannter Weise mittels der Heizvorrichtung 3 zwischen seinem supraleitenden Zustand mit äußerst geringem Widerstand von insbesondere kleiner $10^{-9}$Ohm und seinem normalleitenden höherohmigen Zustand geschaltet werden kann. Der supraleitende Zustand entspricht dabei einem geschlossenen Schalterzustand, während der höherohmige normalleitende Zustand den geöffneten Schalterzustand darstellt. Da der Supraleiter 6 nur verhältnismässig wenig Stabilisierungsmaterial aufweist und zudem in großer Länge um die Trägerplatte 4 gewickelt ist, läßt

0150361

sich hiermit ohne weiteres erreichen, daß mit geringer Heizleistung ein hoher Widerstand von 200 Ohm oder mehr im geöffneten Schalterzustand erhalten wird.

Im geschlossenen Zustand muß dieser so ausgebildete supraleitende Schalter den gesamten Betriebsstrom durch die mit ihm kurzgeschlossene supraleitende Magnetwicklung führen können. Seine Stromtragfähigkeit muß dementsprechend hoch sein. Tritt außerdem ein Störungsfall des Schalters gegebenenfalls auf Grund einer entsprechenden Störung der Magnetwicklung, d. h. ein unbeabsichtigter Übergang vom supraleitenden in den normalleitenden Zustand auf, ist auch dann der Supraleiter 6 auf Grund seiner Teilstabilisierung allein nicht in der Lage, den gesamten Betriebsstrom ohne Überhitzung und damit Beschädigung oder sogar Zerstörung zu übernehmen. Gemäß der Erfindung ist deshalb vorgesehen, daß im geschlossenen Schalterzustand der Schalteinrichtung 2 zusätzlich zu dem teilstabilisierenden Normalleiterquerschnitt des Supraleiters 6 weiteres normalleitendes Material parallelgeschaltet wird, indem dieses zusätzliche Material zumindest den größten Teil des Supraleiters 6 überdeckt und somit zu einer Vollstabilisierung des Supraleiters führt. Hierfür enthält die Schalteinrichtung 2 zusätzlich mindestens zwei plattenförmige, in parallelen Ebenen angeordnete Schaltbacken oder Kontaktstücke 10 und 11 aus einem entsprechenden Stabilisierungsmaterial, z. B. aus Kupfer mit einer Indium- oder Silber-Auflage. Diese beiden Kontaktstücke 10 und 11, von denen das obere Kontaktstück 11 in der Figur nur teilweise veranschaulicht ist, sind mittels einer in der Figur nicht ausgeführten Betätigungsvorrichtung relativ zueinander beweglich und können zum Schließen der Schalteinrichtung 2 an die entsprechenden Flachseiten der zwischen ihnen angeordneten und mit dem Supraleiter 6 bewickelten Heizvorrichtung 3

angefügt werden. Hierbei wird mechanisch auf den Supraleiter 6 das normalleitende Material der Kontaktstücke 10 und 11 aufgepreßt, und zwar vorteilhaft derart, daß die Windungen w des Leiterwickels parallelgeschaltet werden. Auf diese Weise wird eine gute Stromtragfähigkeit und Stabilisierung im geschlossenen Schalterzustand erreicht, ohne daß an den elektrischen Widerstand zwischen den normalleitenden Kontaktstücken 10 und 11 und dem Supraleiter 6 zu hohe Anforderungen gestellt werden müssen. Außerdem ist dabei gewährleistet, daß auch die zwischen den Kontaktstücken verlaufenden und somit nicht unmittelbar von dem zusätzlichen normalleitenden Material überdeckten Teilstücke t des Supraleiters 6 an den Schmalseiten der Trägerplatte 4 auf Grund der Parallelschaltung der Windungen w einen ausreichend hohen Strom tragen können. Die Kontaktstücke 10 und 11 sind an ihren Stirnseiten jeweils mit einem supraleitenden Anschlußleiter 12 bzw. 13 verbunden. Diese Anschlußleiter, bei denen es sich um vollstabilisierte Supraleiter oder auch um Normalleiter mit entsprechend großem Leiterquerschnitt handeln kann, sind mit den mit der Schalteinrichtung 2 kurzzuschließenden Enden der angeschlossenen Magnetwicklung verbunden. Beispielsweise können die Anschlußleiter 12 und 13 direkt die Enden dieser Wicklung sein. Die außerhalb der Schalteinrichtung 2 angeordneten Teile ihres Supraleiters 6 sind somit durch diese Anschlußleiter überbrückt und ausreichend stabilisiert.

Aus der in Fig. 2 gezeigten Schaltskizze der Schalteinrichtung 2 gemäß Fig. 1 sind die elektrischen Verbindungen ihrer einzelnen Bauteile näher ersichtlich. Mit Fig. 1 übereinstimmende Teile sind dabei mit den gleichen Bezugszeichen versehen. Die Anschlußstellen einer nicht dargestellten externen Stromversorgungseinrichtung sind mit 14 und 15 bezeichnet, während an Anschlußpunkten 16 und 17 die nicht ausgeführte supraleitende Magnetwicklung angeschlossen sein soll.

Der Supraleiter 6 der Schalteinrichtung 2 kann unmittelbar in einem seine Supraleitfähigkeit gewährleistenden kryogenen Medium, das insbesondere das Kühlmedium der angeschlossenen supraleitenden Magnetwicklung ist, zusammen mit den Kontaktstücken 10 und 11 angeordnet sein. Gegebenenfalls ist aber auch eine indirekte Kühlung möglich (vgl. DE-OS 25 21 328).

Die verhältnismäßig geringe Betätigungskraft zum Anfügen der Kontaktstücke 10 und 11 an die mit dem Supraleiter 6 bewickelte Heizvorrichtung 3 gestattet nicht nur die Betätigung mittels eines mechanischen Gestänges, sondern es ist auch eine pneumatische oder hydraulische Betätigung möglich. Eine solche Betätigung ist an sich bekannt (vgl. DE-PS 23 24 371).

In dem Ausführungsbeispiel gemäß den Figuren wurde davon ausgegangen, daß die Schalteinrichtung nach der Erfindung ein plattenförmiges Heizelement aufweist, um welches eine Vielzahl von Windungen eines teilstabilisierten Supraleiters gewickelt sind. Gegebenenfalls ist es jedoch möglich, die Windungen des teilstabilisierten Supraleiters z. B. mäanderförmig auch einseitig auf eine Heizvorrichtung aufzubringen, wobei dann die beiden normalleitenden Kontaktstücke an diese Seite so anzufügen sind, daß zwischen ihnen die geforderte Parallelschaltung einzelner Leiterteile dieser Windungen erfolgt.

Neben der in Fig. 1 dargestellten Rechteckform der Flachseiten der Trägerplatte 4 bzw. der Heizvorrichtung 3 können auch andere Gestaltungsformen wie z. B. runde vorgesehen werden. Darüber hinaus brauchen auch nicht die beiden Kontaktstücke 10 und 11 jeweils nur aus einer einzigen Schaltbacke zu bestehen. Gegebenenfalls kann auch jedes Kontaktstück mehrere untereinander parallelgeschaltete Schaltbacken aufweisen.

8 Patentansprüche
2 Figuren

Patentansprüche

1. Schalteinrichtung zum Kurzschließen mindestens einer supraleitenden Magnetwicklung mit mindestens zwei von einem kryogenen Medium zu kühlenden Kontaktstücken, die mittels einer Betätigungsvorrichtung so aneinanderzufügen sind, daß ein supraleitender Strompfad und ein den supraleitenden Strompfad vollstabilisierender normalleitender Strompfad ausgebildet sind, d a d u r c h   g e k e n n z e i c h n e t ,

   a)  daß ein ständig geschlossener Strompfad mit mindestens einem teilstabilisierten Supraleiter (6) mit einem Widerstand von mindestens 200 Ohm im normalleitenden Zustand des Supraleiters (6) vorgesehen ist,

   b)  daß der teilstabilisierte Supraleiter (6) in einer vorbestimmten Anzahl von Windungen (w) mit einer schaltbaren Heizvorrichtung (3) in thermischem Kontakt, elektrisch isoliert verbunden ist,

   c)  daß mindestens zwei Kontaktstücke (10, 11) aus normalleitendem Material vorgesehen sind, die jeweils über einen elektrischen Leiter (12 bzw. 13) an die Magnetwicklung anzuschließen sind, und

   d)  daß an den teilstabilisierten Supraleiter (6) die normalleitenden Kontaktstücke (10, 11) so anzufügen sind, daß die zwischen diesen Kontaktstücken (10, 11) verlaufenden Teilstücke (t) des Supraleiters (6) zumindest teilweise durch die Kontaktstücke (10, 11) parallel geschaltet sind.

2. Schalteinrichtung nach Anspruch 1, d a d u r c h   g e k e n n z e i c h n e t ,   daß der mit dem teilstabilisierten Supraleiter (6) ausgebildete Strompfad einen Mindestwiderstand von 300 Ohm hat.

0150361

3. Schalteinrichtung nach Anspruch 1 oder 2, d a d u r c h  g e k e n n z e i c h n e t , daß die Querschnittsfläche des teilstabilisierten Supraleiters (6) an normalleitendem Stabilisierungsmaterial höchstens gleich der Querschnittsfläche an supraleitendem Material ist.

4. Schalteinrichtung nach einem der Ansprüche 1 bis 3, d a d u r c h  g e k e n n z e i c h n e t , daß die Windungen (w) des teilstabilisierten Supraleiters (6) um die Heizvorrichtung (3) gewickelt sind.

5. Schalteinrichtung nach einem der Ansprüche 1 bis 3, d a d u r c h  g e k e n n z e i c h n e t , daß die Windungen des teilstabilisierten Supraleiters auf einer Flachseite der Heizvorrichtung angeordnet sind und die Kontaktstücke an diese Flachseite anzufügen sind.

6. Schalteinrichtung nach einem der Ansprüche 1 bis 4, d a d u r c h  g e k e n n z e i c h n e t , daß die Heizvorrichtung (3) zwei ebene Flachseiten aufweist, an die jeweils die entsprechend gestaltete Flachseite eines der Kontaktstücke (10 bzw. 11) anzufügen ist.

7. Schalteinrichtung nach einem der Ansprüche 1 bis 6, d a d u r c h  g e k e n n z e i c h n e t , daß die Heizvorrichtung (3) eine elektrisch isolierende Trägerplatte (4) aufweist, durch die sich mindestens eine Heizleitung (5) erstreckt.

8. Schalteinrichtung nach einem der Ansprüche 1 bis 7, d a d u r c h  g e k e n n z e i c h n e t , daß die normalleitenden Kontaktstücke (10, 11) jeweils über einen vollstabilisierten supraleitenden Leiter (12 bzw. 13) mit den Enden der Magnetwicklung verbunden sind.

FIG 1

FIG 2